## Europäisches Patentamt
## European Patent Office
## Office européen des brevets

(19)

(11) Veröffentlichungsnummer: **0 106 199**
**B1**

(12) **EUROPÄISCHE PATENTSCHRIFT**

(45) Veröffentlichungstag der Patentschrift: **23.05.90**

(51) Int. Cl.⁵: **H 03 H 9/64**, H 03 H 9/02

(21) Anmeldenummer: **83109344.8**

(22) Anmeldetag: **20.09.83**

(54) **Oberflächenwellenfilter, sowie Verfahren zur Herstellung einer Bedämpfungsschicht für Oberflächenwellenfilter.**

(30) Priorität: **23.09.82 DE 3235236**

(43) Veröffentlichungstag der Anmeldung:
**25.04.84 Patentblatt 84/17**

(45) Bekanntmachung des Hinweises auf die
Patenterteilung:
**23.05.90 Patentblatt 90/21**

(84) Benannte Vertragsstaaten:
**BE DE FR GB**

(56) Entgegenhaltungen:
**DE-A-2 610 172**

**PATENTS ABSTRACTS OF JAPAN, Band 6, Nr. 67, 28. April 1982, Seite (E-104) 945r & JP - A - 57 7611 (FUJITSU K.K.) 14.01.1982**

**PATENTS ABSTRACTS OF JAPAN, Band 2, Nr. 141, 22. November 1978, Seite 8887 E 78 & JP -A - 53 109 457 (HITACHI SEISAKUSHO K.K.) 09.25.1978**

(73) Patentinhaber: **Siemens Aktiengesellschaft Wittelsbacherplatz 2 D-8000 München 2 (DE)**

(72) Erfinder: **Sinha, Badri Unnützstasse 23 D-8000 München 82 (DE)**

(56) Entgegenhaltungen:
**ELECTRONIC DESIGN, Band 30, Nr. 11, 27. Mai 1982, Seiten 63E-64E; "Smaller monolithic SAW filter is being readied"**

**Die Akte enthält technische Angaben, die nach dem Eingang der Anmeldung eingereicht wurden und die nicht in dieser Patentschrift enthalten sind.**

EP 0 106 199 B1

Courier Press, Leamington Spa, England.

**Beschreibung**

Die Erfindung betrifft ein Oberflächenwellenfilter mit einem plättchenförmigen Substrat aus einkristallinem, piezoelektrischen Werkstoff, insbesondere Lithiumniobat, auf dessen eine Substratseite ggf. mittels eines Kopplers gekoppelte Eingangs- und Ausgangswandler und zur Unterdrückung reflektierter Wellen eine plastische und/oder elastische Bedämpfungsschicht aufgebracht sind, die mindestens bereichsweise diese Substratseite, ausgenommen die Fläche, die durch die Wandler, den Koppler, die Enden der elektrischen Anschlußbahnen und die Bereiche zwischen den Wandlern und dem Koppler begrenzt ist, bedeckt.

Zur Herstellung der Oberflächenwellenfilter wird üblicherweise auf das Substrat eine Metallschicht aufgedampft, aus der z.B. mit Hilfe der Fotoätztechnik die Wandler, — falls erforderlich — auch die Koppler und die Anschlußbahnen samt ihren Enden herausgearbeitet werden. Das so bemusterte Substrat wird auf ein Trägerblech aufgeklebt und die Enden der Anschlußbahnen durch Drahtbonden mit den Anschlußbeinen der Filter elektrisch verbunden. Das System wird danach in ein Metall- oder Kunststoffgehäuse eingesetzt und vergossen.

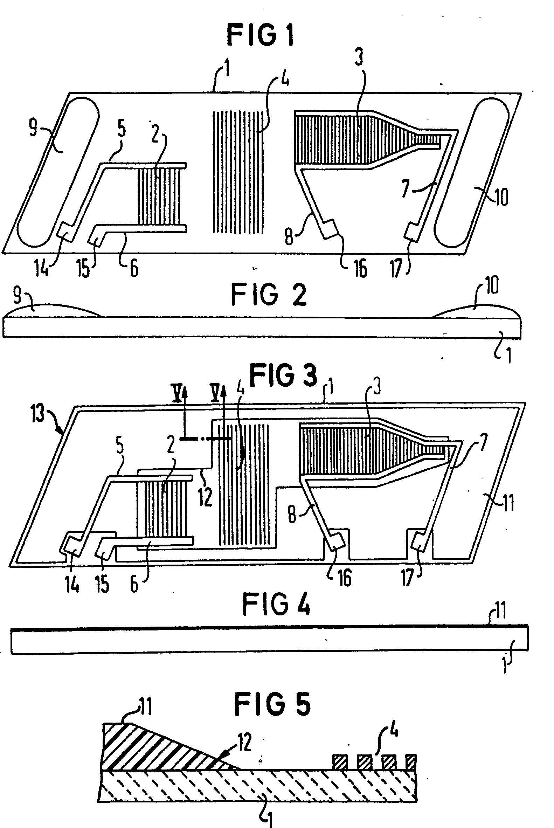

Werden dem Eingangswandler 2 — siehe z.B. das in Figur 1 schematisch in Draufsicht und in Fig. 2 in Seitenansicht gezeigte Ausführungsbeispiel für ein bekanntes, bedämpftes Oberflächenwellenfilter mit Koppler — elektrische Signale zugeführt, so sendet dieser Wandler im gleichen Rhythmus Oberflächenwellen in verschiedenen Richtungen aus. Der Koppler 4, der z.B. aus zueinander parallelen streifenförmigen Leiterbahnen besteht, greift dabei einen Teil und zwar den zum Koppler gerichteten Teil auf und sendet ihn auch in Richtung zum Ausgangswandler 3 weiter, der ihn wieder in elektrische Signale zurückwandelt. Durch technologische Maßnahmen werden reflektierte, insbesondere an Schnittkanten der Substrate entstehende und auch durch Kristallaufbaufehler im Substrat verursachte und somit zeitverzögerte, d.h. störende Wellen teilweise unterdrückt. Beispielsweise wird zu diesem Zweck auf die Flächen zwischen den Substratstirnkanten und den Wandlern 2, 3 eine Bedämpfungsmasse 9, 10, bestehend aus einem Heißkleber, aufgeschmolzen. Verfahrensbedingt kann jedoch nur eine verhältnismäßig kleine Fläche parallel zu den Schnittkanten der Chip-Fläche bedämpft werden. Unerwünschte Reflektionen von Wellen, die störend auf die Wandler 2, 3 und den Koppler 4 einwirken, die sämtlich auf die eine Substratseite eines Substrats 1 aufgebracht sind, sind daher trotz dieser Bedämpfungsmassen unvermeidbar.

In einer verbesserten Ausführung eines Oberflächenwellenfilters, wie sie in der Darstellung nach Fig. 1, 2 in Fig. 3, 4 vorgeschlagen ist, wird im wesentlichen die gesamte, die aktiven und passiven Elemente des Oberflächenwellenfilters tragende Substratseite, ausgenommen die Fläche, die durch die Wandler 2, 3, gegebenenfalls den Koppler 4, die Enden 14, 15, 16, 17 der elektrischen Anschlußbahnen 5, 6, 7, 8 und die Bereiche zwischen den Wandlern und dem Koppler begrenzt ist, durch eine Bedämpfungsschicht 11 bedeckt, bestehend aus Fotolack auf Kunststoffbasis.

Der Auftrag der Bedämpfungsschicht erfolgt dabei mittels fotolithographischem Verfahren; ggf. kann dieser auch mittels Siebdruck oder mittels der s.g. Lochmaskentechnik, d.h. durch Aufsprühen der Bedämpfungsschicht unter Zwischenschaltung einer entsprechend dem gewünschten Schichtmuster durchbrochenen Maske erfolgen. Die so ausgebildete und so aufgetragene Bedämpfungsschicht erzeugt häufig, trotz guter Bedämpfungseigenschaften der verwendeten Bedämpfungsmasse, die im wesentlichen durch die Haftfähigkeit der Bedämpfungsmasse auf dem Substrat, durch die dauerplastische und/oder elastische Konsistenz der Bedämpfungsmasse und durch das aufgetragene Volumen der Bedämpfungsmasse bestimmt sind, starke, störende Reflexionen. Damit wird die durch die Bedämpfungsschicht an sich angestrebte Wirkung, nämlich die weitgehende Unterdrückung der reflektierten, störenden Wellen zunichte gemacht.

Durch die japanische Patentanmeldung JP—A—53 109 457 ist schließlich ein Filter bekannt, bei dem zur Dämpfung der störenden Wellen die Substratstirnkante auf den Schmalseiten des Filters durch Sandblasen oder dergleichen abgeschrägt und ausschließlich der so abgetragene Raum, d.h. nur ein äußerst schmaler Randbereich durch Absorbermaterial aufgefüllt ist. Durch diese Auffüllung mit Absorbermaterial entsteht zwangsläufig eine Bedämpfungsschicht, an deren den Wandlern zugekehrten Stirnseite die Schichtdicke stetig von Null auf einen Maximalwert ansteigt.

Dies erfordert stets einen bestimmten Mindestraum zwischen den Stirnkanten der Substratschmalseiten und den hierzu gekehrten Wandlerenden und damit Oberflächenwellenfilter von unerwünscht großer Länge.

Der vorliegenden Erfindung liegt die Aufgabe zugrunde, ein Oberflächenwellenfilter derart zu bedämpfen, daß nicht nur die von den Stirnkanten des Substrats und durch verschiedenste Kristallaufbaufehler im Substrat verursachten, störenden Wellen, sondern auch die von den Stirnkanten der Bedämpfungsschichten reflektierten, gleichfalls störenden Wellen vollständig unertdrückt werden.

Zur Lösung dieser Aufgabe sieht die Erfindung bei einem Oberflächenwellenfilter gemäß Oberbegriff des Anspruchs 1 vor, daß die Bedämpfungsschicht in gleichmäßige Schichtdicke auf die ebene Substratfläche aufgetragen ist und daß die Schichtdicke an den den Wandlern, den Kopplern und den Anschlußbahnendengebieten jeweils zugekehrten und angrenzenden Stirnkanten mindestens abschnittsweise stetig von Null auf den Wert der gleichmäßigen Schichtdicke ansteigt. Bevorzugt soll dieser Anstieg über die gesamte, zu den Wandlern und — falls vorhanden — dem Koppler gekehrte Stirnkante der Bedämpfungsschicht und ggf. auch im Bereich der zu den Substratkanten gekehrten Stirnkante der Bedämpfungsschicht erfolgen, die, ausgenommen die Fläche, die durch die Wandler, den Koppler, die Enden der Anschlußbahnen und die Bereiche zwischen den Wandlern und dem Koppler begrenzt ist, die gesamte, die aktiven und passiven Elemente tragende Substratseite bedecken kann. Der Anstiegswinkel beträgt dabei max 80°, insbesondere jedoch ca. 1° bis 60°.

Die Schichtdicke selbst ist dabei eine Funktion der Größe der Bedämpfungsschicht und ihrer Beschaffenheit und ist üblich derart gewählt, daß mit abnehmender Fläche die Schichtdicke ansteigt.

Durch diese Ausbildung der Bedämpfungsschicht können sämtliche auftretenden Reflexionen unterdrückt werden, gleichgültig welches der üblichen, geeigneten Verfahren verwendet wird, sofern es nur in einer der nachstehend erläuterten, erfindungsgemäß abgewandelten Ausführungen angewendet wird.

So kann beispielsweise gemäß einem Vorschlag nach der Erfindung eine Fotolackschicht oder allgemeiner ausgedrückt ein lichtempfindlicher Kunstharz auf die mit den aktiven Elementen des Oberflächenwellenfilters bedeckte Substratseite aufgetragen und mittels üblicher fotolithographischer Verfahren aus dieser Schicht die Bedämpfungsschicht herausgearbeitet werden. Durch gezielte Unschärfe der optischen Abbildung der Fotomaske wird dabei der stetige Anstieg der Schichtdicke im Stirnkantenbereich der Bedämpfungsschicht eingestellt.

Die gezielte Unschärfe der optischen Abbildung an sich ist durch entsprechende Wahl des Abstandes zwischen dem Substrat und der Fotolackmaske regelbar.

Geeignet zur Schaffung des stetigen Anstiegs im Stirnkantenbereich der Bedämpfungsschicht ist auch die Siebdrucktechnik bei entsprechend abgewandelter Anwendung. Erfindungsgemäß wird dabei als Bedämpfungsschicht eine ausreichend fließfähige, d.h. nicht thixotrope Siebdruckmasse verwendet, die im üblichen Siebdruckverfahren auf die mit den aktiven Elementen des Oberflächenwellenfilters bedeckte Substratseite aufgetragen wird, wonach mittels anschließender, gezielter Temperung die Bedämpfungsschicht in den Fließzustand versetzt wird, derart, daß die Stirnkante der Bedämpfungsschicht stetig vom Wert der Schichtdicke nach Null abnimmt. Sowohl hinsichtlich ihrer Siebdruck- als auch Bedämpfungsfähigkeit geeignete Stoffe sind glasklare, ungefüllte Epoxidharze auf Zweikomponentenbasis und gefüllte sowie ungefüllte, gut fließfähige Kunststoffe auf Ein- oder Zweikomponentenbasis.

Geeignet ist auch die s.g. Lochmaskentechnik, bei der die Bedämpfungsschicht durch eine dem Substrat vorgeschaltete Lochmaske, die entsprechend dem gewünschten Muster der Bedämpfungsschicht durchbrochen ist, auf das Substrat aufgesprüht wird. Erfindungsgemäß wird dabei im Stirnkantenbereich der Bedämpfungsschicht der stetige Anstieg der Schichtdicke von Null auf den Endwert der Schichtdicke durch den Abstand zwischen der Lochmaske und dem Substrat gesteuert. Die Schichtdicke selbst läßt sich — wie an sich bekannt — durch geeignete Wahl des Sprühdrucks und der Sprühdauer einstellen.

Als Material für die Befämpfungsschicht sind vorzugsweise hochschmelzende, haftfähige Wachse und Paraffine verwendbar, die mittels einer beheizten Druckluftpistole auf das Substrat aufgesprüht werden. Geeignet sind gleichfalls sprüh- und haftfähige Kunstharze, insbesondere Epoxidharze auf Ein- und Zweikomponentenbasis.

Sämtliche genannten Verfahren sind bereits bei Bearbeitung der Wafer, d.h. bei Bearbeitung der in zahlreiche Chip's aufgegliederten, jedoch noch nicht mechanisch zertrennten Substratscheibe anwendbar. Es ergibt sich folglich eine erhebliche, kostensparende Fertigung, da eine Beschichtung der einzelnen Chip's entfällt.

Die Lochmaskentechnik ergibt zusätzlich den Vorteil, daß die Stirnkanten der Bedämpfungsschicht nicht nur stetigen Schichtdickenanstieg aufweisen, sondern darüberhinaus zerfranzt sind, d.h. ungeradlinig verlaufen, wodurch ein weiterer Bedämpfungseffekt erzielt wird. Die Lochmaskentechnik läßt sich auch am drahtgebondeten Einzelchip ausführen, wobei keine Zeitverzögerung auftritt und i.ü. die gebondeten Anschlußbahnen korrosionsgeschützt werden. Zur Durchführung dieser Verfahrensschritte ist lediglich eine zusätzliche Vorrichtung zur Erkennung der Struktur erforderlich.

Ein erfindungsgemäß ausgebildetes und gefertigtes Oberflächenwellenfilter im Detail zeigt Fig. 5, die einen Schnitt gemäß der Linie V V in Fig. 3 wiedergibt.

Bei an sich gleicher Ausführung gemäß Fig. 3, 4 steigt die Stirnkante 12 der auf das Substrat 1 aufgetragenen Bedämpfungsschicht 11, z.B. aus thermoplastischem Material, stetig von Null auf den Wert der Schichtdicke an. Vom Koppler 4 in Richtung zur Bedämpfungsschicht 11 ausgesendete, störende Wellen können, bedingt durch den stetigen Anstieg der Schichtdicke, von der Stirnkante 12 der Bedämpfungsschicht nicht mehr reflektiert werden.

Falls ein Koppler vorhanden ist, hat es sich u.U. als vorteilhaft erwiesen, auch den Koppler mindestens teilweise durch eine Bedämpfungsschicht zu überbrücken — beispielsweise dadurch, daß eine Bedämpfungsschicht streifenförmig von der Anschlußbahn 5 zur Anschlußbahn 8 geführt ist.

**Patentansprüche**

1. Oberflächenwellenfilter mit einem plättchenförmigen Substrat aus einkristallinem, piezoelektrischen Werkstoff, insbesondere Lithiumniobat, auf dessen einer Substratseite ggf. mittels Koppler gekoppelte Eingangs- und Ausgangswandler und zur Unterdrückung reflektierter Wellen eine plastische und/oder elastische Bedämpfungsschicht aufgetragen sind, die mindestens bereichsweise diese Substratseite, ausgenommen die Fläche, die durch die Wandler, den Koppler, die Enden der Anschlußbahnen und die Bereiche zwischen den Wandlern und dem Koppler begrenzt ist, bedeckt, dadurch gekennzeichnet, daß die Bedämpfungsschicht (11) in gleichmäßiger Schichtdicke auf die ebene Substratfläche aufgetragen ist und daß die Schichtdicke an den den Wandlern, den Kopplern und den Anschlußbahnendengebieten jeweils zugekehrten und angrenzenden Stirnkanten mindestens abschnittsweise stetig von Null auf den Wert der gleichmäßigen Schichtdicke ansteigt.

2. Oberflächenwellenfilter nach Anspruch 1, dadurch gekennzeichnet, daß der Anstiegswinkel max. 80°, insbesondere jedoch 1° bis 60° beträgt.

3. Oberflächenwellenfilter nach Anspruch 1, dadurch gekennzeichnet, daß die gesamte, zu den Wandlern (2, 3) und — falls vorhanden — dem Koppler (4) gekehrte Stirnkante (12) der Bedämpfungsschicht (11) stetig von Null auf den Wert der Schichtdicke ansteigt.

4. Oberflächenwellenfilter nach Anspruch 1, 2 und 3, dadurch gekennzeichnet, daß zusätzlich die zu den Substratkanten (13) gekehrte Stirnkante (12) der Bedämpfungsschicht (11) mindestens abschnittsweise stetig von Null auf den Wert der Schichtdicke ansteigt.

5. Oberflächenwellenfilter nach einem der Ansprüche 1 bis 4, dadurch gekennzeichnet, daß die Schichtdicke in Abhängigkeit von der Fläche der Bedämpfungsschicht (11) gewählt ist, derart, daß mit abnehmender Fläche die Schichtdicke ansteigt.

6. Oberflächenwellenfilter nach Anspruch 1, dadurch gekennzeichnet, daß auf den Koppler (4) eine streifenförmige und den Koppler überbrückende Dämpfungsschicht aufgebracht ist.

7. Verfahren zur Herstellung einer Bedämpfungsschicht für ein Oberflächenwellenfilter nach Anspruch 1, dadurch gekennzeichnet, daß eine Fotolackschicht auf die mit den aktiven Elementen (2, 3, 4) des Oberflächenwellenfilters bedeckte Substratseite aufgetragen und mittels fotolithographischem Verfahren aus dieser Fotolackschicht eine Bedämpfungsschicht (11) herausgearbeitet wird, wobei durch gezielte Unschärfe der optischen Abbildung der Fotomaske der stetige Anstieg der Schichtdicke im Stirnkantenbereich (12) eingestellt wird.

8. Verfahren nach Anspruch 7, dadurch gekennzeichnet, daß die gezielte Unschärfe der optischen Abbildung durch die Wahl des Abstandes zwischen Substrat 1 und Maske eingestellt wird.

9. Verfahren nach Anspruch 7 und 8, gekennzeichnet durch die Verwendung lichtempfindlicher Kunstharze.

10. Verfahren zum Herstellen einer Bedämpfungsschicht für ein Oberflächenwellenfilter nach Anspruch 1, dadurch gekennzeichnet, daß als Bedämpfungsschicht (11) eines ausreichend fließfähige Siebdruckmasse im Siebdruckverfahren auf die mit den aktiven Elementen des Oberflächenwellenfilters bedeckte Substratseite aufgetragen und mittels anschließender, gezielter Temperung die Bedämpfungsschicht (11) in den Fließzustand versetzt wird, derart, daß die Stirnkante (12) der Bedämpfungsschicht stetig vom Wert der Schichtdicke nach Null abnimmt.

11. Verfahren nach Anspruch 10, gekennzeichnet durch die Verwendung von Epoxidharz.

12. Verfahren zur Herstellung einer Bedämpfungsschicht für ein Oberflächenwellenfilter nach Anspruch 1, dadurch gekennzeichnet, daß die Bedämpfungsschicht (11) mittels Lochmaskentechnik auf die mit den aktiven Elementen des Oberflächenwellenfilters bedeckte Substratseite aufgesprüht wird, und daß dabei im Stirnkantenbereich (12) der stetige Anstieg der Schichtdicke von Null auf den Endwert der Schichtdicke durch den Abstand zwischen der Lochmaske und dem Substrat (1) gesteuert wird.

13. Verfahren nach Anspruch 12, gekennzeichnet durch die Verwendung hochschmelzender, haftfähiger Wachse und Paraffine.

14. Verfahren nach Anspruch 12, gekennzeichnet durch die Verwendung sprüh- und haftfähiger Kunstharze, insbesondere Epoxidharze.

**Revendications**

1. Filtre à ondes acoustiques de surface comportant un substrat en forme de plaquette en un matériau piézoélectrique monocristallin, en particulier en niobate de lithium, sur un des côtés du substrat duquel sont déposés des transducteurs d'entrée et de sortie, éventuellement couplés à l'aide de coupleurs et une couche d'atténuation plastique et/ou élastique en vue de la suppression d'ondes réfléchies, laquelle couche d'atténuation recouvre au moins par zones ledit côté du substrat, à l'exception de la surface qui est délimitée par les transducteurs, par le coupleur, par les extrémités des pistes de raccordement et les zones situées entre les transducteurs et le coupleur, caractérisé par le fait que la couche d'atténuation (11) est déposée avec une épaisseur de couche uniforme sur la surface plane du substrat et que l'épaisseur de couche au niveau des bords frontaux qui jouxtent et qui sont voisins des transducteurs, des coupleurs et des zones des extrémités des pistes de raccordement, croît au moins par sections et de façon continue, de la valeur zéro à la valeur de l'épaisseur de couche uniforme.

2. Filtre à ondes acoustiques de surface selon la revendication 1, caractérisé par le fait que l'angle de croissance est au maximum égal à 80°, mais en particulier égal de 1° à 60°.

3. Filtre à ondes acoustiques de surface selon la revendication 1, caractérisé par le fait que la totalité du bord frontal (12) de la couche d'atténuation (11), qui est voisin des transducteurs (2, 3) et du coupleur (4)- dans la mesure où celui-ci est prévu-, croît de façon continue de la valeur zéro à la valeur de l'épaisseur de couche.

4. Filtre à ondes acoustiques de surface selon les revendications 1, 2 et 3 caractérisé par le fait qu'en plus, le bord frontal (12) de la couche d'atténuation (11), qui est voisin des bords (13) du substrat, croît, au moins par sections de façon continue de la valeur zéro à la valeur de l'épaisseur de couche.

5. Filtre à ondes acoustiques de surface selon l'une des revendications 1 à 4 caractérisé par le fait que l'épaisseur de la couche est choisie en fonction de la surface de la couche d'atténuation (11) de façon qu'elle croisse avec la diminution de la surface.

6. Filtre à ondes acoustiques de surface selon la revendication 1 caractérisé par le fait que sur le coupleur (4) est déposé une couche d'atténuation en forme de bandes et en pont sur le coupleur.

7. Procédé de fabrication d'une couche d'atténuation pour un filtre à ondes acoustiques de surface selon la revendication 1, caractérisé par le fait qu'une couche d'un vernis photosensible est déposée sur le côté du substrat qui est recouvert avec les éléments actifs (2, 3, 4) du filtre à ondes acoustiques de surface et qu'on en dégage une couche d'atténuation (11) par un procédé de photolithographie, l'accroissement continu de l'épaisseur de la couche étant ajusté, dans la zone du bord frontal (12), par un flou recherché intentionnellement de la formation optique de l'image du photomasque.

8. Procédé selon la revendication 7, caractérisé par le fait que le flou recherché intentionnellement de la reproduction optique est ajusté par le choix de la distance entre le substrat 1 et le masque.

9. Procédé selon la revendication 7 et 8 caractérisé par la mise en oeuvre de résines synthétiques photosensibles.

10. Procédé pour la fabrication d'une couche d'atténuation pour un filtre à ondes acoustiques de surface selon la revendication 1, caractérisé par le fait que l'on dispose, en tant que couche d'atténuation (11), par le procédé de sérigraphie, une masse pour sérigraphie suffisamment coulable, sur le côté du substrat qui est recouvert avec les éléments actifs du filtre à ondes acoustiques de surface, et qu'à l'aide d'un traitement thermique approprié on amène la couche d'atténuation (11) dans son état fluide de façon qu'au moins le bord frontal (12) de la couche d'atténuation décroisse de façon continue de la valeur de l'épaisseur de couche à la valeur zéro.

11. Procédé selon la revendication 10, caractérisé par l'utilisation d'une résine epoxy.

12. Procédé pour fabriquer une couche d'atténuation pour un filtre à ondes acoustiques de surface selon la revendication 1, caractérisé par le fait que la couche d'atténuation (11) est déposée par pulvérisation en technique à masque à trous sur le côté du substrat qui est recouvert avec les éléments actifs du filtre à ondes acoustiques de surface et que ce faisant on contrôle, dans la zone du bord frontal (12), l'accroissement continu de l'épaisseur de couche de la valeur zéro à la valeur finale de l'épaisseur de couche par la distance entre le masque à trous et le substrat (1).

13. Procédé selon la revendication 12, caractérisé par l'utilisation de cires ou de paraffines hautement fusibles et à propriété adhésive.

14. Procédé selon la revendication 12, caractérisé par l'utilisation de résines synthétique capable de pulvérisation et à propriété adhésive, en particulier des résines epoxy.

## Claims

1. Surface wave filter with a slab-shaped substrate of monocrystalline piezoelectric material, particularly lithium niobate, on one substrate side of which input and output transducers optionally coupled by means of a coupler are applied, and a plastic and/or elastic damping layer for suppressing reflected waves is applied, which covers, at least in some regions, said substrate side except for the area which is bounded by the transducers, the coupler, the ends of the conductor runs and the regions between the transducers and the coupler, characterized in that the damping layer (11) is applied with a uniform layer thickness to the plane substrate surface, and in that at the end face edges respectively facing and adjoining the transducers, the couplers and the conductor run end zones the layer thickness increases, at least in sections, with a continuous grade from zero to the value of the uniform layer thickness.

2. Surface wave filter according to Claim 1, characterized in that the slope angle amounts to at most 80°, in particular, however, to 1° to 60°.

3. Surface wave filter according to Claim 1, characterized in that the entire end face edge (12) of the damping layer (11) facing the transducers (2, 3) and — if provided — the coupler (4) increases with a continuous grade from zero to the value of the layer thickness.

4. Surface wave filter according to Claims 1, 2 and 3, characterized in that, additionally, the end face edge (12) of the damping layer (11) facing the substrate edges (13) increases, at least in sections, with a continuous grade from zero to the value of the layer thickness.

5. Surface wave filter according to one of Claims 1 to 4, characterized in that the layer thickness is chosen as a function of the area of the damping layer (11) in such a way that the layer thickness increases with decreasing area.

6. Surface wave filter according to Claim 1, characterized in that a strip-shaped damping layer which bridges the coupler is applied to the coupler (4).

7. Process for fabricating a damping layer for a surface wave filter according to Claim 1, characterized in that a photo-resist layer is applied to the substrate side covered with the active elements (2, 3, 4) of the surface wave filter, and a damping layer (11) is produced from this photo-resist layer by means of a photolithographic process, the continuous increase of the layer thickness in the region of the end face edge (12) being set by controlled unsharpness of the optical imaging of the photomark.

8. Process according to Claim 7, characterized in that the controlled unsharpness of the optical imaging is set by the choice of the spacing between the substrate 1 and mask.

9. Process according to Claims 7 and 8, characterized by the use of light-sensitive synthetic resins.

10. Process for fabricating a damping layer for a surface wave filter according to Claim 1, characterized in that as damping layer (11) a sufficiently flowable screen-printing composition is applied by screen printing onto the substrate side covered with the active elements of the surface wave filter, and by means of subsequent controlled tempering the damping layer (11) is brought into the flowing state in such a way that the end face edge (12) of the damping layer decreases with a continuous grade from the value of the layer thickness to zero.

11. Process according to Claim 10, characterized by the use of epoxy resin.

12. Process for fabricating a damping layer for a surface wave filter according to Claim 1, characterized in that the damping layer (11) is sprayed by means of a perforated mask technique onto the substrate side covered with the active elements of the surface wave filter, and in that in this process the continuous increase in the layer thickness in the region of the end face edge (12) from zero to the final value of the layer thickness is controlled by the spacing between the perforated mask and the substrate (1).

13. Process according to Claim 12, characterized by the use of refractory, adhesive waxes and paraffins.

14. Process according to Claim 12, characterized by the use of sprayable and adhesive synthetic resins, particularly epoxy resins.

EP 0 106 199 B1

FIG 1

FIG 2

FIG 3

FIG 4

FIG 5

1